# EUROPÄISCHE PATENTSCHRIFT

(11) **EP 3 206 468 B1**
(45) Veröffentlichungstag und Bekanntmachung des Hinweises auf die Patenterteilung: **26.12.2018**
(21) Anmeldenummer: 16155697.2
(22) Anmeldetag: 15.02.2016
(51) Int. Cl.: H05K 5/00, H05K 5/02, H05K 5/03, H05K 7/14, H05K 7/20, H02M 7/00

(54) **UMRICHTER MIT GLEICHSPANNUNGSZWISCHENKREIS**
CONVERTER WITH AN INTERMEDIATE D.C. CIRCUIT
CONVERTISSEUR DOTÉ D'UN CIRCUIT INTERMÉDIAIRE À TENSION CONTINUE

(43) Veröffentlichungstag der Anmeldung: 16.08.2017
(73) Patentinhaber: Siemens Aktiengesellschaft, 80333 München (DE)
(72) Erfinder: Neumeister, Matthias, 90469 Nürnberg (DE); Kraus, Ludwig, 94099 Ruhstorf (DE); Meraviglia, Dario, 91325 Adelsdorf (DE); Mondal, Gopal, 91058 Erlangen (DE)

(56) Entgegenhaltungen:
- EP-A2- 1 965 424
- EP-A2- 2 535 928
- EP-A2- 2 587 908
- EP-A2- 2 654 392
- DE-A1- 10 153 748
- JP-A- 2007 258 458

## Beschreibung

Die Erfindung betrifft einen Umrichter mit Gleichspannungszwischenkreis zur Umwandlung einer Eingangsspannung in eine Wechselspannung mit vorbestimmter Amplitude und Frequenz für die Ansteuerung einer ein- oder mehrphasigen Last.

Leistungsmodule heutiger Wechselrichter werden mit Hilfe eines luft- oder wassergekühlten Kühlkörpers, der aus einem gut Wärme leitendem Material, z.B. Aluminium, besteht, gekühlt. Für einen besseren Wärmeübergang zu dem Kühlkörper wird ein aus Kupfer oder anderen Materialien bestehender Träger mit Wärmeleitpaste an dem Kühlkörper befestigt. Auf dem Träger ist eine, beidseitig mit einer Kupferkaschierung versehene, Keramik gelötet. Auf der von dem Träger abgewandten Seite der kupferkaschierten Keramik sind die elektronischen Komponenten des Leistungsmoduls angeordnet. Die Dicke der kupferkaschierten Keramik ist dabei in erster Linie von der erforderlichen Spannungsfestigkeit abhängig. Andererseits bestimmt die Dicke der kupferkaschierten Keramik den Wärmedurchgang in Richtung des Kühlkörpers. Dies bedeutet, je höher die Leistungsklasse eines Leistungsmoduls ist, desto schwieriger wird die Entwärmung in Richtung des Kühlkörpers.

Ein weiterer Nachteil besteht darin, dass die Kontaktierung der einzelnen Leistungsmodule aufgrund des leitfähigen Kühlkörpers entsprechend groß sein muss, um erforderliche Sicherheitsabstände einzuhalten. Eine platzsparende, kompakte Bauweise ist daher nur schwer realisierbar.

Aus der EP 2587908 A2 ist ein Umrichter zur Umwandlung einer Eingangsspannung in eine Wechselspannung für die Ansteuerung einer ein- oder mehrphasigen Last bekannt, mit einer Anzahl an übereinander stapelbar ausgebildeten Modulen, wobei jedes Modul elektronische Komponenten umfasst, die im Betrieb des Umrichters von einem Kühlmedium kühlbar sind, wobei zumindest ein Zwischenkreiskondensator sowie eingangs- und ausgangsseitige Leistungsanschlüssen vorhanden sind und wobei eine Steuereinheit zur Ansteuerung der elektronischen Komponenten vorhanden ist.

Aus der DE 10153748 A1 sind eine Stromrichtereinheit in Modulbauweise und ein entsprechendes Stromrichtergerät bekannt. Die Stromrichtereinheit umfasst dabei eine doppelseitig bestückbare Kühleinrichtung und eine aus mehreren Kondensatoren bestehende Zwischenkreis-Kondensatorbatterie, die über- einander in einem Montagerahmen angeordnet sind. Weiterhin ist auf wenigstens einer Montageplatte wenigstens ein Leistungsmodul mit zugehöriger Ansteuerbaugruppe und zugehörigem Stromschienensystem angeordnet und ist der Montagerahmen mit Blechen zu einem Kühlkanal vervollständigt.

Aus der EP 2654392 A2 sind eine Anordnung und hierfür ein anreihbares Leistungshalbleitermodul mit einer quaderförmigen, jeweils zwei sich jeweils paarweise gegenüberliegenden Haupt-Längs- und Schmalseiten aufweisenden Grundform bekannt, weiter mit einer durchströmbaren Kühleinrichtung, einer leistungselektronischen Schalteinrichtung und einem Gehäuse. Die Kühleinrichtung weist ein Kühlvolumen mit mindestens einer Kühlfläche und vier Anschlusseinrichtungen für die Kühlflüssigkeit auf, die paarweise an den Hauptseiten angeordnet sind. Weiterhin sind die Anschlusseinrichtungen für die Kühlflüssigkeit ausgebildet als jeweils ein Vorlaufzu- und ein Vorlaufabfluss sowie als ein Rücklaufzu- und ein Rücklaufabfluss. Die leistungselektronische Schalteinrichtung weist Lasteingangs- und Lastausgangsanschlusseinrichtungen auf, die jeweils an einer oder beiden Längsseiten angeordnet sind sowie eine Steueranschlusseinrichtung, die an einer Schmalseite des Leistungshalbleitermoduls angeordnet ist.

Es ist Aufgabe der vorliegenden Erfindung, einen Umrichter mit einem Gleichspannungszwischenkreis zur Umwandlung einer Eingangsspannung in eine Wechselspannung anzugeben, welcher verbessert entwärmt werden kann und gleichzeitig einen geringeren Volumenbedarf aufweist.

Diese Aufgabe wird gelöst durch einen Umrichter gemäß den Merkmalen des Patentanspruches 1. Vorteilhafte Ausgestaltungen ergeben sich aus den abhängigen Patentansprüchen.

Zur Lösung der Aufgabe wird ein Umrichter mit einer Anzahl an übereinander stapelbar ausgebildeten Modulen vorgeschlagen. Jedes Modul umfasst einen keramischen Kühlkörper mit einer Aufnahmefläche, auf der elektronische Komponenten einer Phase aufgenommen sind, wobei der keramische Kühlkörper im Bereich der Aufnahmefläche einen oder mehrere Kanäle aufweist, die im Betrieb des Umrichters von einem Kühlmedium durchströmbar sind. Der Umrichter umfasst ferner zumindest einen Zwischenkreiskondensator sowie eingangs- und ausgangsseitige Leistungsanschlüsse auf einem ersten Träger, dessen Hauptebene senkrecht zu der Ebene der Aufnahmefläche angeordnet ist. Der Umrichter umfasst zudem eine Steuereinheit zur Ansteuerung der elektronischen Komponenten der Phase, wobei die Steuereinheit auf einem zweiten Träger angeordnet ist, dessen Hauptebene senkrecht zu der Ebene der Aufnahmefläche angeordnet ist.

Die Verwendung des keramischen Kühlkörpers ermöglicht einen kompakten und modularen Aufbau eines Umrichters.

Bei einem Umrichter mit einer Mehrzahl an übereinander gestapelten Modulen können der oder die den Modulen zugeordneten Zwischenkreiskondensatoren gemeinsamen auf dem ersten Träger angeordnet sein. Ebenso kann bei mehreren Modulen eine gemeinsame Steuereinheit zur Ansteuerung der elektronischen Komponenten der jeweiligen Module verwendet werden, die auf dem zweiten Träger angeordnet ist.

Die Stapelbarkeit einer Mehrzahl von Modulen übereinander ergibt sich durch die Verwendung eines aktiv gekühlten keramischen Kühlkörpers. Dadurch, dass der Kühlkörper mit einem oder mehreren Kanälen versehen ist, die im Betrieb des Umrichters von einem Kühlmedium durchströmbar sind, kann der bislang verwendete Kühlkörper aus Aluminium entfallen. Ebenso sind die bislang erforderliche Bodenplatte, welche über eine Wärmeleitpaste an den metallenen Kühlkörper angebunden ist, nicht mehr erforderlich. Dies ermöglicht größere Freiheitsgrade bei der Ausgestaltung des Umrichters im Hinblick auf eine Skalierung.

Der geringere Volumenbedarf gegenüber einem herkömmlichen Umrichter ergibt sich durch die Verwendung des keramischen Kühlkörpers, der es erlaubt, den oder die Zwischenkreiskondensatoren auf dem ersten Träger und die Steuereinheit auf dem zweiten Träger anzuordnen, wobei der erste und der zweite Träger jeweils senkrecht zu der Ebene der Aufnahmefläche angeordnet sind. Hierdurch können Leitungslängen zwischen den einzelnen Komponenten erheblich reduziert werden, mit den damit verbundenen Vorteilen geringerer Streuinduktivitäten. Daraus resultierend ergeben sich geringere Schaltverluste. Insbesondere ist es möglich, die elektronischen Komponenten einer Phase, z.B. einer Halbbrücke, mit größerer Frequenz anzusteuern.

Gemäß einer zweckmäßigen Ausgestaltung ist zumindest an zwei gegenüberliegenden Seiten der Aufnahmefläche jeweils ein Konstruktionsträger angeordnet, wobei die Konstruktionsträger, in einer Richtung senkrecht zur Aufnahmefläche, über die Aufnahmefläche hinausragen, so dass die elektronischen Komponenten dann in einer zwischen der Aufnahmefläche und den Konstruktionsträgern gebildeten Vertiefung liegen, wobei die Konstruktionsträger an ihren in Erstreckungsrichtung liegenden Enden Anlageabschnitte für ein benachbartes Modul aufweisen. Die Konstruktionsträger ermöglichen einen robusten mechanischen Aufbau des Kühlkörpers. Darüber hinaus kann die Zufuhr und die Abfuhr des Kühlmediums insbesondere bei einer Mehrzahl von übereinander gestapelten Modulen über die Konstruktionsträger vorgenommen werden. Dies erleichtert die Kühlung der elektronischen Komponenten des Umrichters.

Gemäß einer zweckmäßigen Ausgestaltung beträgt die Dicke des Kühlkörpers im Bereich der Aufnahmefläche in einer Richtung senkrecht zur Ebene der Aufnahmefläche zwischen 3 mm und 5 mm. Die Dicke der Konstruktionsträger in einer Richtung senkrecht zur Ebene der Aufnahmefläche beträgt zweckmäßigerweise zwischen 15 mm und 20 mm. Dies bedeutet, die Höhe eines einzigen Moduls beträgt zwischen 15 mm und 20 mm und entspricht der Dicke des Konstruktionsträgers. Soll z.B. eine Mehrzahl an Modulen parallel geschaltet werden, so kann dies durch Übereinanderstapeln der gewünschten Anzahl an Modulen erfolgen. Dadurch ergibt sich ein Modulverbund mit einer bestimmten Anzahl an einzelnen Modulen, welche an ein gemeinsames Kühlsystem angeschlossen sind. Gleichzeitig ergibt sich ein kompakter Aufbau, dessen Höhe von der Anzahl der übereinander gestapelten Module abhängt. Der Anzahl an übereinander gestapelten Modulen kann, wie bereits erläutert, der gemeinsame erste Träger mit dem oder den Zwischenkreiskondensatoren und der gemeinsame zweite Träger mit der gemeinsamen Steuereinheit zugeordnet und mit dieser verbunden sein.

Gemäß einer weiteren zweckmäßigen Ausgestaltung ist über den oder die Konstruktionsträger dem oder den Kanälen des Kühlkörpers das Kühlmedium zuführbar und von diesen abführbar. Es ist besonders zweckmäßig, wenn über einen der Konstruktionsträger das Kühlmedium dem oder den Kanälen des Kühlkörpers zugeführt und über den anderen der beiden Konstruktionsträger das Kühlmedium von den Kanälen des Kühlkörpers abgeführt wird.

Gemäß einer weiteren zweckmäßigen Ausgestaltung ist in dem oder den Konstruktionsträgern ein sich senkrecht zur Ebene der Aufnahmefläche erstreckender Zulaufsammelkanal für die Zufuhr des Kühlmediums zu dem oder den Kanälen vorgesehen und ein sich senkrecht zur Ebene der Aufnahmefläche erstreckender Ablaufsammelkanal für die Abfuhr des Kühlmediums vorgesehen, wobei das jeweilige Volumen des Zulaufsammelkanals und des Ablaufsammelkanals sehr viel größer als das Volumen des oder der im Bereich der Aufnahmefläche angeordneten Kanäle ist. Hierdurch kann eine gute Wärmeabfuhr über das Kühlmedium bereitgestellt werden. Insbesondere kann durch das größere Volumen des Zulaufsammelkanals und des Ablaufsammelkanals gegenüber dem Volumen des oder der Kanäle sichergestellt werden, dass auch bei einer großen Anzahl an übereinander gestapelten Module die elektronischen Komponenten jedes einzelnen Moduls gleichmäßig entwärmt werden.

Gemäß einer weiteren zweckmäßigen Ausgestaltung sind die Konstruktionsträger aus einem keramischen Werkstoff und einstückig mit dem Kühlkörper mit der Aufnahmefläche ausgebildet. Gemäß einer alternativen Ausgestaltung sind die Konstruktionsträger aus einem anderen Werkstoff wie der Kühlkörper mit der Aufnahmefläche gebildet und sind form- und/oder kraftschlüssig miteinander verbunden. Während eine einstückige Ausgestaltung des Kühlkörpers, bei der die Konstruktionskörper und der Kühlkörper mit der Aufnahmefläche aus einem keramischen Werkstoff ausgebildet sind, eine hervorragende Entwärmung ermöglichen, kann eine Variante, bei der die Konstruktionsträger aus einem anderen Werkstoff, z.B. Aluminium, gebildet sind, mit geringeren Kosten hergestellt werden. Dabei ist die Entwärmung geringfügig schlechter als bei der zuerst genannten Variante.

Gemäß einer weiteren zweckmäßigen Ausgestaltung ist zum Verschluss der Vertiefung auf beiden Seiten der Vertiefung jeweils eine Dichtplatte vorgesehen, die einen Durchtritt für Steueranschlüsse oder Versorgungs- und Lastanschlüsse umfassen. Durch das Vorsehen der Dichtplatten ist sichergestellt, dass die im Inneren der Vertiefung angeordneten elektronischen Komponenten auf einfache Weise gegen Einflüsse von außen, wie z.B. Schmutz oder Feuchtigkeit, geschützt werden können. Ein Schutz von oben erfolgt dabei entweder durch ein über dem betreffenden Modul anderes Modul oder über eine gesonderte Abschlussplatte.

Es ist insbesondere vorgesehen, dass die Steueranschlüsse durch eine erste der Dichtplatten durchtreten, wobei die Steueranschlüsse außerhalb des Moduls mit dem zweiten Träger durch Steckverbindung mechanisch und elektrisch verbunden sind. Auf diese Weise ergibt sich eine einfache Fertigung des Umrichters. Insbesondere kann die Steckverbindung auch dann genutzt werden, wenn eine Mehrzahl von Modulen zu einem Modulverbund übereinander gestapelt ist.

Es ist insbesondere weiter vorgesehen, dass die Versorgungsanschlüsse und der Lastanschluss durch eine zweite der Dichtplatten durchtreten, wobei die Versorgungsanschlüsse außerhalb des Moduls mit einer ersten Hauptseite des ersten Trägers mechanisch und elektrisch verbunden sind. Dabei ist es zweckmäßig, wenn sich die Breite der jeweiligen Versorgungs- und Lastanschlüsse über einen Großteil der Breite der Vertiefung erstreckt, um die Stromtragfähigkeit durch eine große Oberfläche der Anschlüsse zu erhöhen. Eine große Fläche begünstigt darüber hinaus auch ein schnelles Schaltverhalten, d.h. einen Betrieb des Umrichters mit hoher Frequenz.

Gemäß einer weiteren Ausgestaltung sind der oder die Zwischenkreiskondensatoren auf einer zweiten Hauptseite des Trägers angeordnet. Umgekehrt bedeutet dies, dass die Module auf der ersten Hauptseite des ersten Trägers angeordnet sind. Dadurch ergibt sich der kompakte Aufbau mit den geringen Leitungslängen zur Optimierung der Induktivität.

Es ist weiterhin zweckmäßig, wenn ein erster und ein zweiter Versorgungsanschluss durch übereinander angeordnete und mit einer Isolationsschicht voneinander getrennte Blechschienen gebildet sind. Dadurch lassen sich zum einen hohe Ströme übertragen. Zum anderen können die Blechschienen auf einfache und kostengünstige Weise bereitgestellt werden. Durch die parallele Führung der Blechschienen des ersten und des zweiten Versorgungsanschlusses ergibt sich ein kapazitiver Effekt zwischen den Versorgungsanschlüssen. Dadurch lässt sich in gewünschter Weise die Reduktion von parasitären Induktivitäten erzielen. Weiterhin ermöglicht dies die ebenfalls erwähnte großflächige Stromführung zur Bereitstellung einer großen Stromtragfähigkeit, geringen Verlusten und einem schnellen Schaltverhalten. Durch das parallele Führen der Blechschienen wird darüber hinaus ein Wirbelstromeffekt vorteilhaft ausgenutzt.

Gemäß einer weiteren zweckmäßigen Ausgestaltung ist der Lastanschluss als weitere Blechschiene ausgeführt, die über den Blechschienen der Versorgungsanschlüsse geführt und von diesen über eine Isolationsschicht getrennt ist. Diese Anordnung ermöglicht einen einfachen und mechanisch robusten Aufbau. Darüber hinaus kann auch eine hohe Stromtragfähigkeit des Lastanschlusses sichergestellt werden.

Gemäß einer weiteren Ausgestaltung sind mehrere übereinander angeordnete Module mechanisch miteinander verbunden zur Ausbildung eines Modulverbunds. Zum Beispiel können die Module des Modulverbunds über Gewindestangen zu dem Verbund verpresst sein. Die Gewindestangen können z.B. durch Bohrungen in den Konstruktionsträgern geführt sein. Wie oben bereits erwähnt, ist es nicht erforderlich, bei einem Modulverbund für jedes Modul eine eigenständige Steuereinheit sowie dezidiert zugeordnete Zwischenkreiskondensatoren vorzusehen. Vielmehr können diese Funktionseinheiten gemeinsam für alle Module des Modulverbunds bereitgestellt werden, insbesondere wenn die Module elektrisch parallel angesteuert und geschaltet werden sollen.

Es ist weiterhin zweckmäßig, wenn der Umrichter eine Anzahl der Phasen entsprechende Anzahl an Modulverbünden umfasst.

Gemäß einer weiteren zweckmäßigen Ausgestaltung ist ein jeweiliger Modulverbund mit einem gemeinsamen zweiten Träger verbunden. Der zweite Träger liegt vorzugsweise im sog. Euroformat vor, unabhängig von der Anzahl der miteinander verbundenen Module des Modulverbunds.

Gemäß einer weiteren zweckmäßigen Ausgestaltung sind alle Modulverbünde des Umrichters mit dem ersten Träger mechanisch und elektrisch verbunden. So kann beispielsweise bei einer B6-Brückenschaltung vorgesehen sein, alle Zwischenkreiskondensatoren mit dem ersten Träger zu verbinden.

Die Erfindung wird nachfolgend näher anhand eines Ausführungsbeispiels in der Zeichnung erläutert. Es zeigen:
- Fig. 1: eine Draufsicht auf ein Modul eines erfindungsgemäßen Umrichters;
- Fig. 2: eine Seitenansicht des Moduls aus Fig. 1;
- Fig. 3: eine Ansicht des Moduls aus Fig. 1 von einer Seite her, über welche eine Steuerung von elektronischen Komponenten des Moduls erfolgt;
- Fig. 4: eine Seitenansicht des Moduls aus Fig. 1 von einer, der Ansicht in Fig. 2 gegenüberliegenden Seite her;
- Fig. 5: eine Ansicht des Moduls aus Fig. 1 von Seiten der Lastanschlüsse her;
- Fig. 6: eine Ansicht des Moduls aus Fig. 1 von unten;
- Fig. 7: eine perspektivische Ansicht eines Modulverbunds, der aus vier übereinander angeordneten Modulen besteht, welche, wie in den Figuren 1 bis 6 gezeigt, ausgebildet sind;
- Fig. 8: zeigt eine perspektivische Darstellung eines Modulverbunds mit insgesamt sieben übereinander gestapelten Modulen, welche gemäß den Figuren 1 bis 6 ausgebildet sind, wobei ein zweiter Träger für eine Steuereinheit mit den Modulen verbunden ist;
- Fig. 9: zeigt eine Draufsicht auf einen erfindungsgemäßen Umrichter, bei dem drei Modulverbünde zur Bereitstellung jeweiliger Phasen an einem ersten Träger befestigt sind, wobei jeder der Modulverbünde aus jeweils sieben übereinandergestapelten Modulen gemäß den Figuren 1 bis 6 besteht;
- Fig. 10: eine Ansicht des Umrichters aus Fig. 9 von der Seite;
- Fig. 11: den Umrichter der Figuren 9 und 10 in einer anderen Seitenansicht; und
- Fig. 12: den Umrichter der Figuren 9 bis 11 von unten.

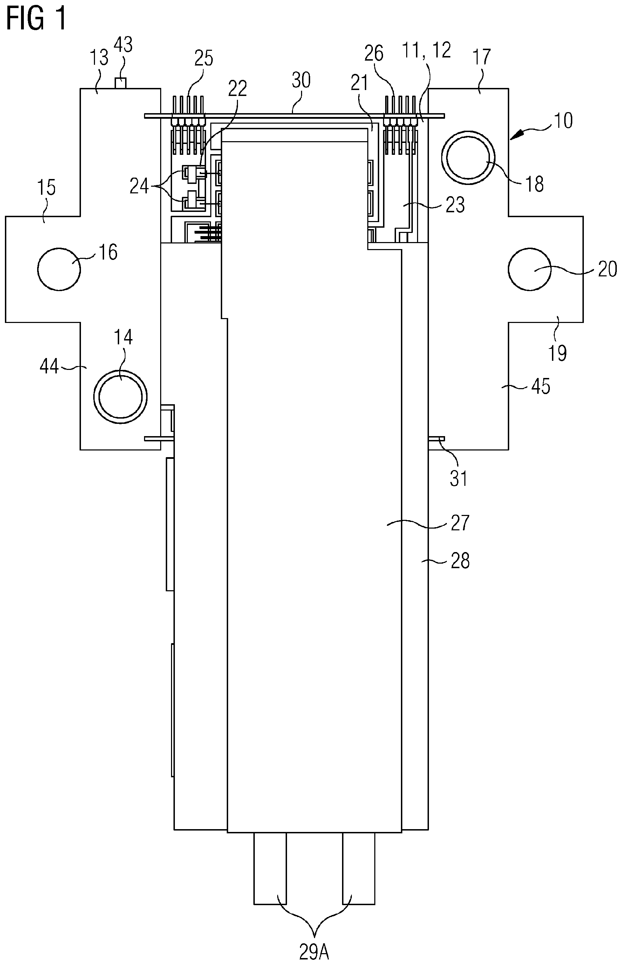

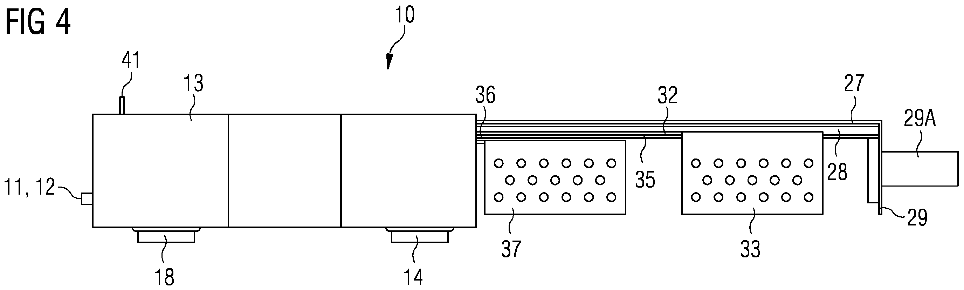

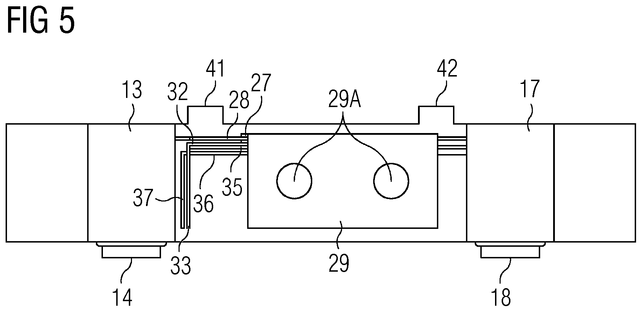

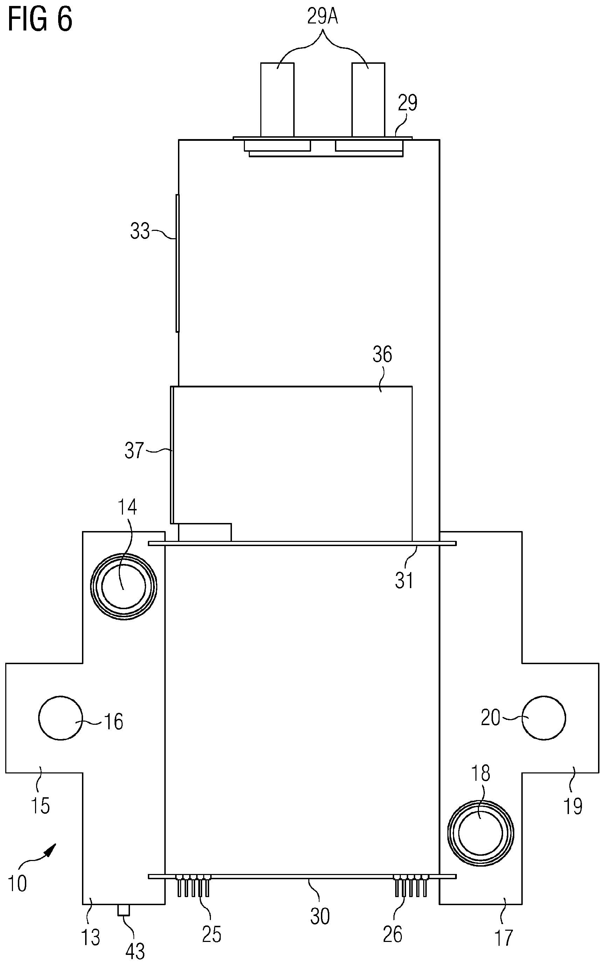

Die Figuren 1 bis 6 zeigen ein Ausführungsbeispiel eines erfindungsgemäßen Moduls 10, welches einzeln oder übereinander gestapelt und zu einem Modulverbund vereinigt, in einem erfindungsgemäßen Umrichter mit Gleichspannungszwischenkreis zur Umwandlung einer Eingangsspannung in eine Wechselspannung mit vorbestimmter Amplitude und Frequenz für die Ansteuerung einer in den Figuren nicht gezeigten ein- oder mehrphasigen Last genutzt werden kann.

In den Figuren sind gleiche Elemente mit gleichen Bezugszeichen versehen.

Fig. 1 zeigt eine Draufsicht auf das Modul 10. Das Modul 10 umfasst einen keramischen Kühlkörper 11 mit einer Aufnahmefläche 12. In der Darstellung der Fig. 1 erstreckt sich die Aufnahmefläche 12 parallel zur Zeichenebene. Auf der Aufnahmefläche 12 sind leitfähige Bereiche 21, 22, 23 aufgebracht, auf denen eine Mehrzahl an elektronischen Komponenten 24 aufgebracht ist. Die elektronischen Komponenten 24 sind beispielsweise ein oder mehrere Halbleiterschaltelemente sowie ein oder mehrere Dioden. Über die Aufnahmefläche 12 wird eine Verschaltung der elektronischen Komponenten untereinander vorgenommen. Hierzu erfolgt in einer dem Fachmann bekannten Weise die Verschaltung der elektronischen Komponenten beispielsweise mit Hilfe von Leiterdrähten (sog. Bonddrähte), welche entweder elektronische Komponenten 24 unmittelbar miteinander oder eine elektronische Komponente 24 mit einem leitfähigen Bereich 21, 22, 23 auf der Aufnahmefläche 12 miteinander verbinden. In dem Modul 10 sind die elektronischen Komponenten 24 derart verschaltet, dass diese einen Zweig einer Phase des Umrichters ausbilden. Beispielsweise können die elektronischen Komponenten 24 hierzu in einer Halbbrücke miteinander verschaltet sein.

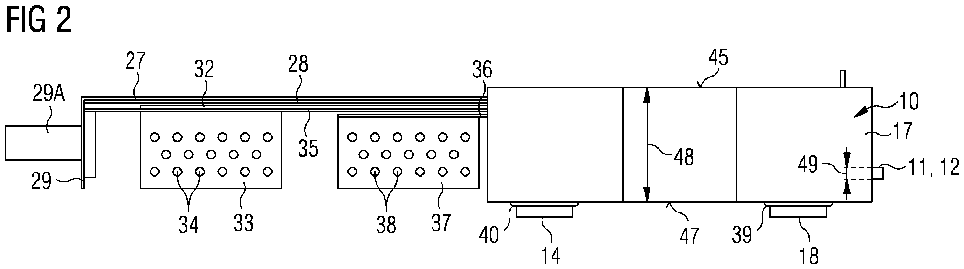

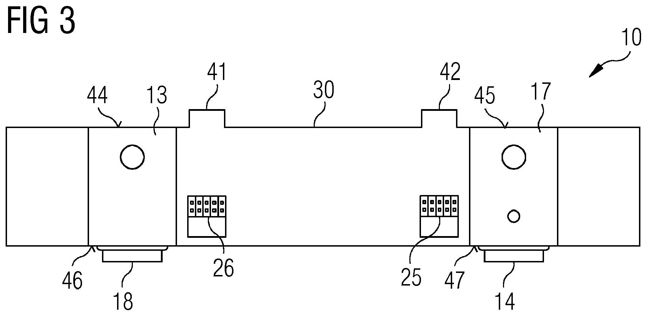

An zwei gegenüberliegenden Seiten der Aufnahmefläche 12 des aus einem keramischen Material gebildeten Kühlkörpers 11 ist jeweils ein Konstruktionsträger 13, 17 angeordnet. Die Konstruktionsträger 13, 17 erstrecken sich dabei in der in Fig. 1 gezeigten Darstellung über die gesamte Länge der Seitenkanten des Kühlkörpers 11 in Blattrichtung von oben nach unten. Die Konstruktionsträger 13, 17 ragen in einer Richtung senkrecht zur Aufnahmefläche 12, d.h. senkrecht zur Blattebene, über die Aufnahmefläche 12 hinaus. Dadurch sind die elektronischen Komponenten 24 in einer zwischen der Aufnahmefläche 12 und den Konstruktionsträgern 13, 17 gebildeten Vertiefung angeordnet. In der gezeigten Darstellung erstrecken sich die Konstruktionsträger somit aus der Zeichenebene, in Richtung auf den Betrachter zu, hinaus. Die mit den Bezugszeichen 44 und 45 gekennzeichneten Abschnitte der Konstruktionsträger 13, 17 bilden dem Betrachter zugewandte Anlageabschnitte für ein benachbartes Modul. Auf den gegenüberliegenden Seiten der Konstruktionsträger 13, 17 weisen die Konstruktionsträger korrespondierende Anlageabschnitte 46, 47 auf, wie beispielsweise den Seitenansichten der Figuren 2 und 3 besser entnehmbar ist.

Während die Dicke der Konstruktionsträger 13, 17 senkrecht zur Ebene der Aufnahmefläche zwischen 15 mm und 20 mm beträgt und damit die "Höhe" des Moduls festlegt, beträgt die Dicke des Kühlkörpers 11 im Bereich der Aufnahmefläche 12 senkrecht zur Ebene der Aufnahmefläche 12 zwischen 3 mm und 5 mm. Die Dicke des Konstruktionsträgers ist in Fig. 2 mit 48, die Dicke des Kühlkörpers im Bereich der Aufnahmefläche mit dem Bezugszeichen 49 gekennzeichnet.

In den Figuren 1 bis 6 nicht ersichtlich sind in dem keramischen Kühlkörper 11 vorgesehene Kanäle, die im Bereich der Aufnahmefläche (geradlinig, schlängenförmig, o.ä.) verlaufen. Im Betrieb des Umrichters werden die Kanäle zur Kühlung der auf der Aufnahmefläche 12 angeordneten elektronischen Komponenten 24 von einem Kühlmedium, z.B. Wasser, durchströmt. Die Zufuhr bzw. Abfuhr des Kühlmediums zu dem oder den Kanälen des Kühlkörpers 11 erfolgt im hier beschriebenen Ausführungsbeispiel über die beiden an gegenüberliegenden Seiten des Kühlkörpers angeordneten Konstruktionsträger 13, 17. Zu diesem Zweck verfügt der Konstruktionsträger 13 über einen Zulaufsammelkanal 14 und der Konstruktionsträger 17 über einen Ablaufsammelkanal 18. Der Zulaufsammelkanal 14 und der Ablaufsammelkanal 18 erstrecken sich senkrecht zur Ebene der Aufnahmefläche 12. Der Zulaufsammelkanal 14 und der Ablaufsammelkanal 18 sind - in den Figuren nicht ersichtlich - in geeigneter Weise mit den Kanälen des Kühlkörpers 11 strömungstechnisch verbunden. Es ist dabei zweckmäßig, wenn das jeweilige Volumen des Zulaufsammelkanals 14 und des Ablaufsammelkanals 18 sehr viel größer ist als das Volumen des oder der im Bereich der Aufnahmefläche 12 des Kühlkörpers 11 angeordneten Kanäle, um eine gute Wärmeabfuhr der von den elektronischen Komponenten erzeugten Wärme sicherzustellen. Zu diesem Zweck können der Zulaufsammelkanal 14 und der Ablaufsammelkanal 18 im Inneren des betreffenden Konstruktionsträgers 13, 17 mit einer entsprechenden Kavität verbunden sein oder in diese übergehen.

Wie beispielsweise aus den Seitendarstellungen der Figuren 2 und 3 ersichtlich ist, weisen der Zulaufsammelkanal 14 und der Ablaufsammelkanal 18 an ihrem unteren Ende zwei über die Hauptseite des Kühlkörpers 11 hinausragende Stutzen auf. Diese Stutzen können in entsprechende Aussparungen des Zulaufsammelkanals 14 und des Ablaufsammelkanals 18 eines benachbarten Moduls zur Bildung eines Modulverbunds gesteckt werden. Zur Abdichtung der Verbindung zwischen zwei benachbarten Modulen 10 sind die Stutzen des Zulaufsammelkanals 14 und des Ablaufsammelkanals 18 mit jeweiligen Dichtungen 39, 40 (z.B. O-Ringe) umgeben. Die Dichtungen 39, 40 können in entsprechenden Aussparungen des benachbarten Moduls des zugeordneten Zulaufsammelkanals und Ablaufsammelkanals verquetscht werden.

In dem in den Figuren 1 bis 6 beschriebenen Ausführungsbeispiel eines erfindungsgemäßen Moduls 10 bestehen die Konstruktionsträger 13, 17 wie der Kühlkörper 11 aus einem keramischen Werkstoff und sind einstückig ausgebildet. Dies bedeutet, der Kühlkörper 11 mit dessen Aufnahmefläche 12 und die Konstruktionsträger 13, 17 bilden eine, insbesondere nicht lösbare, Einheit.

In einem anderen Ausführungsbeispiel können die Konstruktionsträger 13, 17 aus einem anderen Werkstoff wie der Kühlkörper 11 mit der Aufnahmefläche 12 gebildet sein. Vorzugsweise ist der andere Werkstoff gut wärmeleitend und mechanisch stabil. Aus Kostengründen bietet sich beispielsweise die Ausgestaltung der Konstruktionsträger 13, 17 aus Aluminium oder einem anderen Metall an. Konstruktiv sind die Konstruktionsträger 13, 17 dann form- und/oder kraftschlüssig mit dem Kühlkörper 11 mit der Aufnahmefläche 12 miteinander verbunden.

Um mehrere Module 10-1, ..., 10-n (wobei n eine grundsätzlich beliebige Zahl ist) zur Ausbildung eines Modulverbunds 100 miteinander verbinden zu können, weist der Konstruktionsträger 13 einen Befestigungsabschnitt 15 mit einer Bohrung 16 auf. In entsprechender Weise weist der Konstruktionsträger 17 einen Befestigungsabschnitt 19 mit einer Bohrung 20 auf. Lediglich beispielhaft kommen die Befestigungsabschnitte 15, 19 gegenüber zum Liegen. Die Bohrungen 16, 19 erstrecken sich über die gesamte Höhe bzw. Dicke des Konstruktionsträgers 13, 17 bzw. deren Befestigungsabschnitte 15, 19.

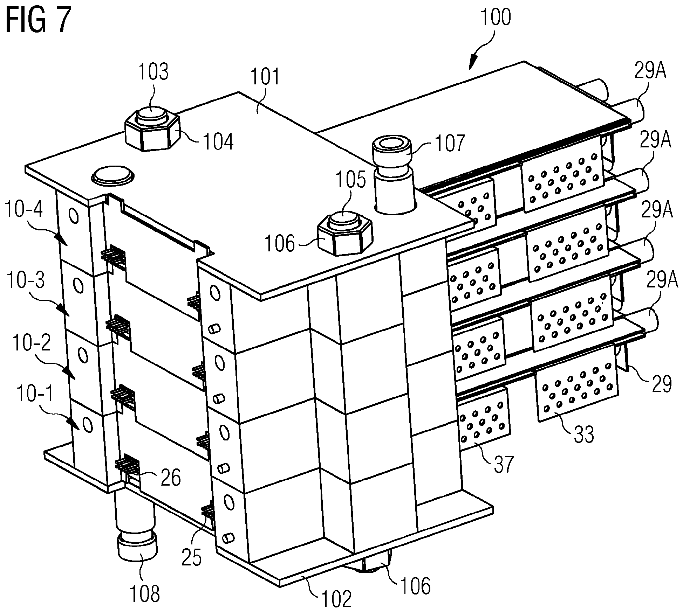

Wie aus Fig. 7 hervorgeht, welche einen Modulverbund 100 mit beispielhaft n = 4 übereinander gestapelten Modulen 10-1, ..., 10-4 darstellt, ist durch die Bohrungen 16 und 20 jeweils eine Gewindestange 103 bzw. 105 geführt. Als äußere Begrenzung des Modulverbunds 100 sind im Bereich der jeweils äußersten Module 10-1 und 10-4 Druckplatten 101 und 102 angeordnet, wobei die Gewindestangen 103 und 105 die Druckplatten 101 und 102 ebenfalls durchdringen. Über an den beiden gegenüberliegenden Enden der Gewindestangen 103, 105 geschraubte Muttern 104 bzw. 106 sind die Module 10-1 bis 10-4 miteinander verspannt.

In entsprechender Weise kann der Fig. 7 entnommen werden, dass die jeweiligen Zulaufsammelkanäle 14 der Anzahl an Modulen 10-1 bis 10-4 sich über die gesamte Dicke des Modulverbunds 100 erstrecken. In entsprechender Weise erstrecken sich die Ablaufsammelkanäle 18 der Anzahl an Modulen 10-1 bis 10-4 über die gesamte Höhe des Modulverbunds 100. Mit dem Bezugszeichen 107 ist ein gemeinsamer Zulauf des Modulverbunds und mit dem Bezugszeichen 108 ein gemeinsamer Ablauf des Modulverbunds 100 gekennzeichnet. Durch die Anordnung des gemeinsamen Zulaufs 107 an der oberen Druckplatte 101 und des gemeinsamen Ablaufs 108 an der unteren Druckplatte 102 ist sichergestellt, dass eine gleichmäßige Wärmeabfuhr der von den elektronischen Komponenten der unterschiedlichen Module 10-1 bis 10-4 erfolgt.

Nachfolgend wird erneut auf die Ausgestaltung eines einzelnen Moduls 10 und die Figuren 1 bis 6 Bezug genommen. Zum Verschluss der zwischen der Aufnahmefläche 12 und den Konstruktionsträgers 13, 17 gebildeten Vertiefung ist auf beiden offenen Seiten der Vertiefung jeweils eine Dichtplatte 30, 31 vorgesehen. Die Dichtplatten 30, 31 bestehen aus einem isolierenden Werkstoff, z.B. einem Kunststoff.

Durch die Dichtplatte 30 tritt eine Anzahl an Steueranschlüssen 25, 26 (jeweils in Gestalt einer Anzahl an Kontaktpins) hindurch. Die Steueranschlüsse 25, 26 werden außerhalb des Moduls 10 mit einer später beschriebenen Steuereinheit elektrisch und mechanisch verbunden. Über die Steueranschlüsse 25, 26 können steuerbare Halbleiterschaltelemente des Moduls 10 angesteuert werden. Wie am besten aus Fig. 3 ersehen werden kann, weist die Dichtplatte 30 an ihrem nach oben gerichteten Ende zwei Vorsprünge 41, 42 auf. Diese Vorsprünge 41, 42 können in entsprechende Aufnahmen oder Laschen der Dichtplatte des darüber gestapelten Moduls mechanisch eingreifen, um einen hermetischen Abschluss des Volumens der Vertiefung sicherzustellen. Aus Fig. 3 geht darüber hinaus gut hervor, dass sich die Steueranschlüsse 25, 26 in etwa senkrecht aus der Ebene der Dichtplatte 30 heraus erstrecken.

Durch die Dichtplatte 31 treten eine Blechschiene 32 eines ersten Versorgungsanschlusses 33 (z.B. des Minus-Pols), eine Blechschiene 36 eines zweiten Versorgungsanschlusses 37 (z.B. eines Plus-Pols) sowie eine Blechschiene 27 eines Lastanschlusses 29 hindurch. Wie am besten den Seitenansichten der Figuren 2, 4 und 5 entnommen werden kann, ist zwischen den Blechschichten 32 und 36 eine Isolationsschicht 35 und zwischen den Blechschichten 27 und 32 eine Isolationsschicht 28 angeordnet. Wie ebenfalls den genannten Seitenansichten entnehmbar ist, erstrecken sich die Blechschichten 27, 32 und 36 in dem hier gezeigten Ausführungsbeispiel in unterschiedlichen Längen seitlich aus dem Kühlkörper 11 heraus, wobei sie parallel zur Ebene der Aufnahmefläche 12 verlaufen. Die eigentlichen Kontaktflächen, d.h. der erste Versorgungsanschluss 33, der zweite Versorgungsanschluss 37 sowie der Lastanschluss 29, sind gegenüber der Verlaufsebene der Blechschienen 27, 32, 36 um 90° nach unten (d.h. hier in Richtung der Aufnahmefläche 12) gebogen. Über diese "Laschen" erfolgt dann die elektrische und/oder mechanische Kontaktierung der betreffenden Anschlüsse. Diese Ausgestaltung ist lediglich beispielhaft.

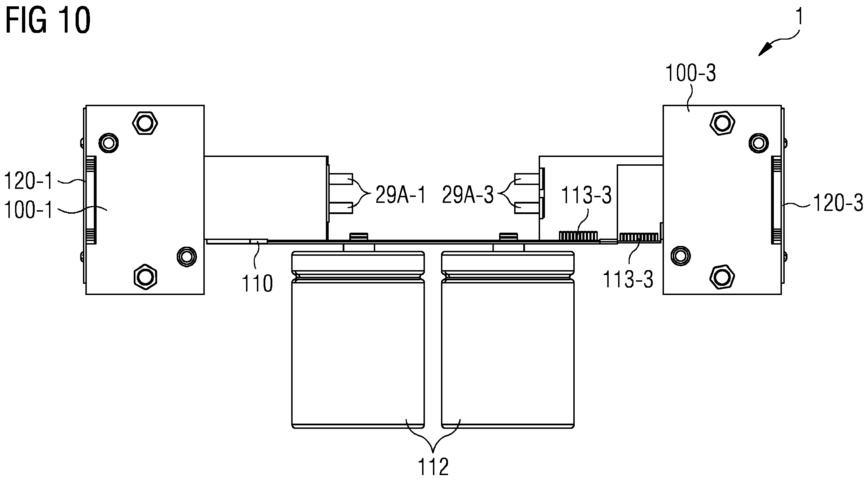

Der erste Versorgungsanschluss 33 und der zweite Versorgungsanschluss 37 weisen jeweils eine Anzahl an Bohrungen 34, 38 auf, in welche in einem später beschriebenen Träger 110 Kontaktpins 113 eingepresst werden. Dies kann exemplarisch der Fig. 10 entnommen werden. Durch den Lastanschluss 29 sind beispielhaft zwei Schrauben oder Schraubbolzen 29A geführt, so dass über nicht näher dargestellte, darauf geschraubte Leitungen die zu versorgende Last angeschlossen werden kann.

Während die Blechschienen 32, 36 der Versorgungsanschlüsse 33, 37 und die Blechschiene 27 des Lastanschlusses 29 aus einem Metall, vorzugsweise Kupfer oder einer Kupferlegierung, gebildet sind, bestehen die Isolationsschichten 28, 35 aus einem isolierenden Material, z.B. Makrolon oder Polyethylen (PE) .

Wie am besten aus Fig. 1 ersichtlich ist, ist das von dem Lastanschluss 29 abgewandte Ende der Blechschiene 27 mit einem leitfähigen Bereich 21 auf der Aufnahmefläche 12 des keramischen Kühlkörpers 11 verbunden. Die Verbindung kann beispielsweise durch Löten erfolgen. In entsprechender Weise können die Blechschienen 32, 36 des ersten und des zweiten Versorgungsanschlusses 33, 37 mit den leitfähigen Bereichen 22, 23 auf der Aufnahmefläche 12 des keramischen Kühlkörpers 11 elektrisch leitend verbunden sein.

Fig. 7 zeigt in einer perspektivischen Darstellung eine beispielhafte Ausgestaltung eines Modulverbunds 100 mit lediglich beispielhaft vier übereinander gestapelten Modulen 10-1, ..., 10-4, welche jeweils, wie in den Figuren 1 bis 6 beschrieben, ausgebildet sind. Die mechanische Verbindung über die Gewindestangen 103 und 105 sowie die Zufuhr und Abfuhr des Kühlmediums wurde bereits erläutert.

Aus der perspektivischen Darstellung der Fig. 7 ist gut ersichtlich, dass die Steueranschlüsse 25, 26 eines jeden Moduls 10-1 bis 10-4 zur gleichen Seite des Modulverbunds 100 hin gerichtet sind. In entsprechender Weise sind die Lastanschlüsse 29 mit den Schrauben 29A sowie die Versorgungsanschlüsse 33, 37 auf der anderen Seite des Modulverbunds 100 angeordnet. So kann ohne weiteres ersehen werden, dass insbesondere die jeweiligen Versorgungsanschlüsse 33 und 37 der vier übereinander gestapelten Module 10-1 bis 10-4 in einer gemeinsamen Ebene liegen, welche sich senkrecht zur Ebene der Aufnahmeflächen 12 der jeweiligen Module 10-1 bis 10-4 und senkrecht zur Erstreckungsrichtung der Blechschienen 27, 32, 36 erstreckt. Die Ebene, in denen die Steueranschlüsse 25, 26 liegen, ist parallel zu der Ebene, in der die Lastanschlüsse 29 mit den Schrauben 29A liegen.

Ein wie in Fig. 7 gezeigter Modulverbund 100 dient beispielsweise zur Steuerung einer Phase einer nicht gezeigten Last. Hierzu werden die elektronischen Komponenten jedes Moduls 10-1 bis 10-4 mit Hilfe einer Steuerschaltung gemeinsam und parallel angesteuert, so dass an den Lastanschlüssen 29 ein entsprechender Laststrom verfügbar ist, der der Phase der Last zugeführt wird. Durch die Anzahl der übereinander gestapelten Module 10 kann dadurch die von einem Modulverbund 100 mögliche maximale Leistung eingestellt werden.

In einer anderen Ausgestaltung ist es auch möglich, an den Lastanschlüssen unterschiedlicher Module 10-1 bis 10-4 unterschiedliche Phasen einer oder mehrerer Lasten anzuschließen.

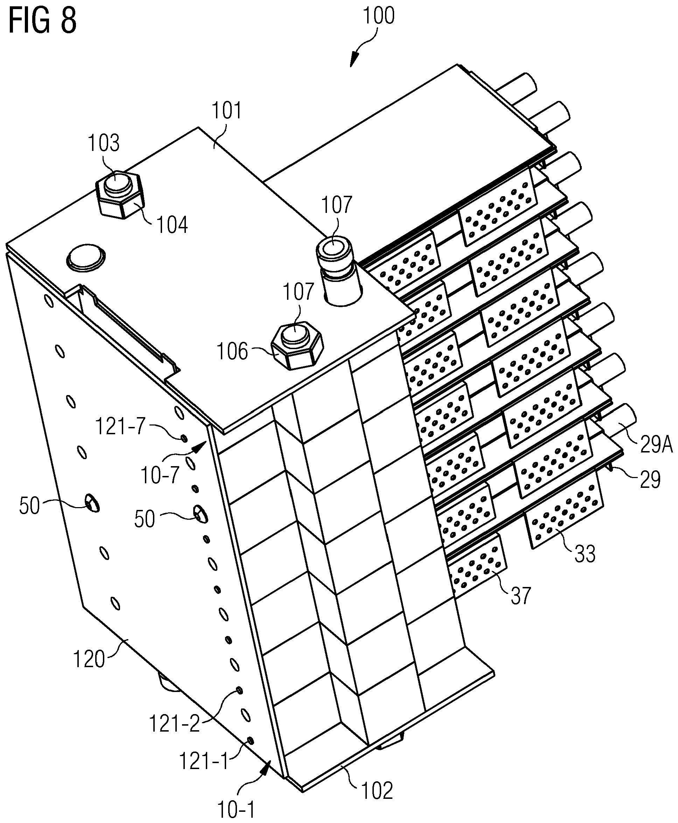

Fig. 8 zeigt in einer perspektivischen Darstellung einen Modulverbund 100 mit nunmehr beispielhaft sieben übereinander gestapelten identischen Modulen 10-1, ..., 10-7. Mit dem Bezugszeichen 120 ist ein Träger, z.B. eine Leiterplatte, gekennzeichnet, auf dem Komponenten der nicht dargestellten Steuereinheit aufgebracht sind. Durch entsprechende Kontaktelemente werden auf der in Fig. 8 nicht sichtbaren Rückseite die Steueranschlüsse 25, 26 elektrisch und mechanisch kontaktiert. Eine Positionierung des Trägers 120 erfolgt über die an einem jeweiligen Modul 10 (genauer dem Konstruktionsträger 13) angeordnete Positionierzapfen 43, welche in entsprechende Aussparungen 121 des Trägers 120 eingreifen. Auf der dem Betrachter zugewandten Hauptseite des Trägers 120 sind die Komponenten der Steuereinheit angeordnet.

Wie ohne weiteres dieser Darstellung zu entnehmen ist, ist die Hauptebene des Trägers 120 der Steuereinheit senkrecht zu der Ebene der Aufnahmeflächen 12 der Module 10-1 bis 10-7 des Modulverbunds 100 angeordnet.

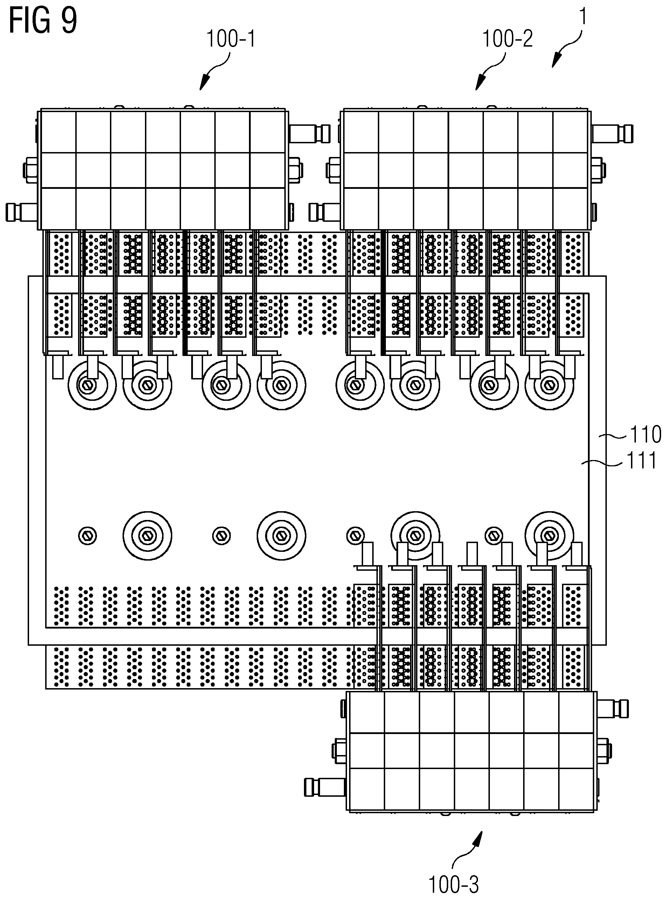

In den Figuren 9 bis 12 ist ein Ausführungsbeispiel eines erfindungsgemäßen Umrichters 1 mit drei, wie zuvor beschriebenen Modulverbünden 100-1, 100-2 und 100-3 aus verschiedenen Perspektiven dargestellt. Dabei dient der Modulverbund 100-1 zur Bereitstellung eines Stroms für eine erste Phase einer nicht dargestellten Last. In entsprechender Weise stellt der Modulverbund 100-2 den Strom für eine zweite Phase der Last und der Modulverbund 100-3 den Strom für eine dritte Phase der Last bereit. Bei dem Umrichter 1 handelt es sich beispielsweise um einen B6-Umrichter. Dies bedeutet, dass jeder Modulverbund 100-1, 100-2, 100-3 als Halbbrücke ausgebildet ist. Die elektrischen Komponenten jedes Moduls 10 jedes Modulverbunds 100-1, 100-2, 100-3 sind dann parallel verschaltet.

Lediglich beispielhaft weist jeder Modulverbund 100-1 sieben (d.h. n = 7) übereinander gestapelte Module, wie diese in Verbindung mit den Figuren 1 bis 6 beschrieben wurden, auf. Die Anzahl n könnte natürlich auch anders gewählt sein.

Wie aus der Draufsicht der Fig. 9 hervorgeht, sind die Modulverbünde 100-1, 100-2 und 100-3 über ihre Lastanschlüsse 29 mit entsprechenden Kontaktpins 113 auf dem bereits erwähnten Träger 110 mechanisch und elektrisch befestigt. Diese Art der Kontaktierung, die mit Hilfe einer Kaltverschweißung erfolgen kann, geht besser aus der Seitenansicht der Fig. 10 hervor. Auf der in Fig. 9 dem Betrachter zugewandten Hauptseite des Trägers 110 ist eine leitfähige Schicht 111 angeordnet. Diese flächig auf der Hauptseite des Trägers 110 angeordnete leitfähige Schicht 111 dient zur elektrischen Abschirmung.

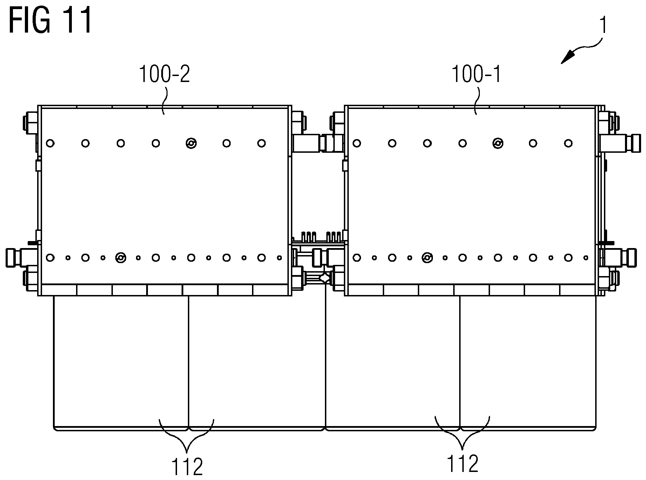

Wie der Seitendarstellung der Figuren 10 und 11 entnehmbar ist, sind auf der anderen Hauptseite des Trägers 110 mehrere Kondensatoren 112 angeordnet, welche sog. Zwischenkreiskondensatoren darstellen. Es ist ohne weiteres ersichtlich, dass die Hauptebene des Trägers 110, auf dem die (parallel verschalteten) Zwischenkreiskondensatoren angeordnet sind, senkrecht zu der Ebene der Aufnahmeflächen der Module 10 eines jeweiligen Modulverbunds 100-1, 100-2, 100-3 angeordnet ist.

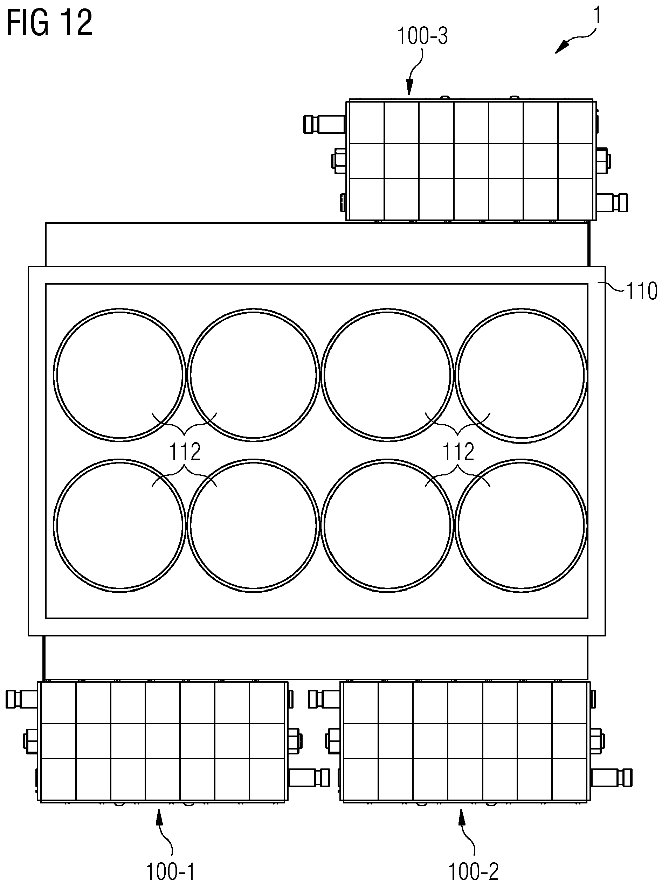

Wie beispielsweise der Ansicht von unten in Fig. 12 entnehmbar ist, wird jeder Modulverbund 100-1, 100-2, 100-3 von einem eigenen Kühlkreislauf mit Kühlmedium versorgt. Dadurch ist eine gleichmäßige Kühlung sämtlicher elektronischer Komponenten aller Modulverbünde 100-1, 100-2, 100-3 ermöglicht.

Aus den Darstellungen der Figuren 9 und 10 ist besonders gut ersichtlich, dass das hier verwirklichte Prinzip, die elektronischen Komponenten einer oder mehrerer Phasen in einer ersten Ebene anzuordnen, den Zwischenkreiskondensator auf einem Träger anzuordnen, dessen Hauptebene senkrecht zu der Ebene der Aufnahmefläche der elektronischen Komponenten der einzelnen Module und die Steuereinheit auf einem Träger anzuordnen, dessen Hauptebene ebenfalls senkrecht zu der Ebene der Aufnahmefläche angeordnet ist, einen besonders kompakten und insbesondere nach Belieben modular aufgebauten Umrichter 1 ermöglicht.

Im hier gezeigten Ausführungsbeispiel stehen die genannten drei Ebenen jeweils senkrecht zueinander. In einer Abwandlung könnte auch vorgesehen sein, die Modulverbünde 100-1, 100-2 und 100-3 relativ zur Hauptebene des Trägers 110 derart zu drehen, dass die Hauptebene des Trägers 110 parallel zu den Hauptebenen der Träger 120-1, 120-2 und 120-3 für die jeweiligen Steuereinheiten der Modulverbünde 100-1, 100-2 und 100-3 liegt. Dies erfordert lediglich eine Anpassung im Bereich der Ausgestaltung der Blechschienen 32, 36 und 27 sowie der zugeordneten Lastanschlüsse 33, 37 und 29.

Ermöglicht wird diese kompakte und platzsparende Anordnung durch die Verwendung keramischer Kühlkörper der Module. Dadurch, dass diese in beliebiger Anzahl übereinandergestapelt werden können, kann durch eine parallele Verschaltung die Leistung eines jeweiligen Modulverbunds skaliert werden. Das Stapeln der einzelnen Module führt zu einer effizienten Montage, da keine zusätzlichen Aufwendungen hinsichtlich Kühlanschlüssen der einzelnen Kühlkörper erforderlich sind. Darüber hinaus kann auch eine Entwärmung der Steuereinheit über den Träger 120 und den direkten Kontakt mit den Stirnseiten der Konstruktionsträger 13, 17 erfolgen.

Durch die genannte Anordnung der Ebenen zueinander können darüber hinaus aufgrund kurzer Leitungsverbindungen parasitäre Induktivitäten minimiert werden. Insbesondere lassen sich dadurch kleine Kommutierungszellen in einem jeweiligen Modul realisieren. Eine Schwingneigung kann durch einen Dämpfungswiderstand in Verbindung mit den Zwischenkreiskondensatoren 112 realisiert werden. Der Dämpfungswiderstand kann auf der Aufnahmefläche 12 eines jeweiligen Moduls 10 vorgesehen werden.

Bei einer Parallelschaltung mehrerer Module in einem Modulverbund braucht unabhängig von der Anzahl der Module in dem Modulverbund nur ein Treiberlayout der Steuereinheit bereitgestellt werden. Vorzugsweise wird der Träger 120 im Euroformat (d.h. in einer Größe von 100 mm x 160 mm) bereitgestellt, so dass durch einen mehrlagigen Aufbau kurze Leitungswege zur Synchronisation von Laufzeiten realisierbar sind. Gegebenenfalls können einzelne Steckplätze, sofern die Anzahl der Module eines Modulverbunds zu gering ist, frei bleiben. Die elektronischen Komponenten der Steuereinheit sorgen für eine niederinduktive, identische (d.h. synchrone) Ansteuerung der einzelnen Module. Eine leichte Montage der Steuereinheit erfolgt durch Steckmontage mit den Steueranschlüssen 25, 26. Die optimale Anbindung des Trägers 120 an die Konstruktionsträger 13, 17 erfolgt mit Halteschrauben, um einen für die Kühlung optimierten Anpressdruck zu erzeugen. Diese Halteschrauben sind in Fig. 8 mit dem Bezugszeichen 50 gekennzeichnet.

Aufgrund der Möglichkeit, die Blechschienen 27, 32 und 36 großflächig ausführen und parallel zueinander führen zu können, ergibt sich eine erwünschte Reduktion von parasitären Induklivilälen. Darüber hinaus wird eine große Stromtragfähigkeit zur Minimierung von Verlusten sichergestellt. Dies ermöglicht es, die elektronischen Komponenten, insbesondere die Halbleiterschaltelemente, mit hoher Frequenz zu schalten.

## Patentansprüche

1. Umrichter mit Gleichspannungszwischenkreis zur Umwandlung einer Eingangsspannung in eine Wechselspannung mit vorbestimmter Amplitude und Frequenz für die Ansteuerung einer ein- oder mehrphasigen Last, mit
- einer Anzahl an übereinander stapelbar ausgebildeten Modulen (10; 10-1,...,10-7), wobei jedes Modul (10; 10-1,...,10-7) einen keramischen Kühlkörper (11) mit einer Aufnahmefläche (12) umfasst, auf der elektronische Komponenten (24) einer Phase aufgenommen sind, wobei der keramische Kühlkörper (11) im Bereich der Aufnahmefläche (12) einen oder mehrere Kanäle aufweist, die im Betrieb des Umrichters (1) von einem Kühlmedium durchströmbar sind;
- zumindest einem Zwischenkreiskondensator (112) sowie eingangs- und ausgangsseitige Leistungsanschlüssen, die auf einem ersten Träger (110) angeordnet sind, dessen Hauptebene senkrecht zu der Ebene der Aufnahmefläche (12) angeordnet ist;
- einer Steuereinheit zur Ansteuerung der elektronischen Komponenten (24) der Phase, wobei die Steuereinheit auf einem zweiten Träger (120) angeordnet ist, dessen Hauptebene senkrecht zu der Ebene der Aufnahmefläche (12) angeordnet ist.

2. Umrichter nach Anspruch 1, **dadurch gekennzeichnet, dass** zumindest an zwei gegenüberliegenden Seiten der Aufnahmefläche (12) jeweils ein Konstruktionsträger (13, 17) angeordnet ist, wobei die Konstruktionsträger (13, 17), in einer Richtung senkrecht zur Aufnahmefläche (12), über die Aufnahmefläche (12) hinausragen, so dass die elektronischen Komponenten (24) dann in einer zwischen der Aufnahmefläche (12) und den Konstruktionsträgern (13, 17) gebildeten Vertiefung liegen, wobei die Konstruktionsträger (13, 17) an ihren in Erstreckungsrichtung liegenden Enden Anlageabschnitte (44,...,47) für ein benachbartes Modul (10; 10-1,...,10-7) aufweisen.

3. Umrichter nach Anspruch 1 oder 2, **dadurch gekennzeichnet, dass** die Dicke des Kühlkörpers (11) im Bereich der Aufnahmefläche (12) in einer Richtung senkrecht zur Ebene der Aufnahmefläche (12) zwischen 3 mm und 5 mm beträgt.

4. Umrichter nach Anspruch 2 oder 3, **dadurch gekennzeichnet, dass** die Dicke der Konstruktionsträger (13, 17) in einer Richtung senkrecht zur Ebene der Aufnahmefläche (12) zwischen 15 mm und 20 mm beträgt.

5. Umrichter nach einem der Ansprüche 2 bis 4, **dadurch gekennzeichnet, dass** über den oder die Konstruktionsträger (13, 17) dem oder den Kanälen des Kühlkörpers (11) das Kühlmedium zuführbar und von diesen abführbar ist.

6. Umrichter nach Anspruch 5, **dadurch gekennzeichnet, dass** in dem oder den Konstruktionsträgern (13, 17) ein sich senkrecht zur Ebene der Aufnahmefläche (12) erstreckender Zulaufsammelkanal (14) für die Zufuhr des Kühlmediums zu dem oder den Kanälen vorgesehen ist und ein sich senkrecht zur Ebene der Aufnahmefläche (12) erstreckender Ablaufsammelkanal (18) für die Abfuhr des Kühlmediums vorgesehen ist, wobei das jeweilige Volumen des Zulaufsammelkanals (14) und des Ablaufsammelkanals (18) sehr viel größer als das Volumen des oder der im Bereich der Aufnahmefläche (12) angeordneten Kanäle ist.

7. Umrichter nach einem der Ansprüche 2 bis 6, **dadurch gekennzeichnet, dass** die Konstruktionsträger (13, 17) aus einem keramischen Werkstoff und einstückig mit dem Kühlkörper (11) mit der Aufnahmefläche (12) ausgebildet sind.

8. Umrichter nach einem der Ansprüche 2 bis 6, **dadurch gekennzeichnet, dass** die Konstruktionsträger (13, 17) aus einem anderen Werkstoff wie der Kühlkörper (11) mit der Aufnahmefläche (12) gebildet sind und form- und/oder kraftschlüssig miteinander verbunden sind.

9. Umrichter nach einem der vorhergehenden Ansprüche, **dadurch gekennzeichnet, dass** zum Verschluss der Vertiefung auf beiden Seiten der Vertiefung jeweils eine Dichtplatte (30, 31) vorgesehen ist, die einen Durchtritt für Steueranschlüsse oder Versorgungs- und Lastanschlüsse umfassen.

10. Umrichter nach Anspruch 9, **dadurch gekennzeichnet, dass** die Steueranschlüsse durch eine erste der Dichtplatten (30) durchtreten, wobei die Steueranschlüsse außerhalb des Moduls (10; 10-1,...,10-7) mit dem zweiten Träger (120) durch Steckverbindung mechanisch und elektrisch verbunden sind.

11. Umrichter nach Anspruch 9 oder 10, **dadurch gekennzeichnet, dass** die Versorgungsanschlüsse und der Lastanschluss durch eine zweite der Dichtplatten (31) durchtreten, wobei die Versorgungsanschlüsse außerhalb des Moduls (10; 10-1,...,10-7) mit einer ersten Hauptseite des ersten Trägers (110) mechanisch und elektrisch verbunden sind.

12. Umrichter nach Anspruch 11, **dadurch gekennzeichnet, dass** der oder die Zwischenkreiskondensatoren (112) auf einer zweiten Hauptseite des ersten Trägers (110) angeordnet sind.

13. Umrichter nach einem der Ansprüche 9 bis 12, **dadurch gekennzeichnet, dass** ein erster und ein zweiter Versorgungsanschluss durch übereinander angeordnete und mit einer Isolationsschicht (35) voneinander getrennte Blechschienen (32, 36) gebildet sind.

14. Umrichter nach einem der Ansprüche 9 bis 12, **dadurch gekennzeichnet, dass** der Lastanschluss als weitere Blechschiene (27) ausgeführt ist, die über den Blechschienen (32, 36) der Versorgungsanschlüsse geführt und von diesen über eine Isolationsschicht (28) getrennt ist.

15. Umrichter nach einem der vorhergehenden Ansprüche, **dadurch gekennzeichnet, dass** mehrere übereinander angeordnete Module (10; 10-1,...,10-7) mechanisch miteinander verbunden sind zur Ausbildung eines Modulverbunds (100-1, 100-2, 100-3) .

16. Umrichter nach Anspruch 15, **dadurch gekennzeichnet, dass** dieser eine Anzahl der Phasen entsprechende Anzahl an Modulverbünden (100-1, 100-2, 100-3) umfasst.

17. Umrichter nach Anspruch 15 oder 16, **dadurch gekennzeichnet, dass** ein jeweiliger Modulverbund (100-1, 100-2, 100-3) mit einem gemeinsamen zweiten Träger (120-1, 120-2, 120-3) verbunden ist.

18. Umrichter nach einem der Ansprüche 15 bis 17, **dadurch gekennzeichnet, dass** ein jeweiliger Modulverbund (100-1, 100-2, 100-3) mit dem ersten Träger (110) verbunden ist.

## Claims

1. Converter with a DC link for converting an input voltage into an alternating voltage with a pre-determined amplitude and frequency for driving a single or multiple-phase load, comprising
- a number of modules (10; 10-1, ..., 10-7) which are configured stackable over one another, wherein each module (10; 10-1, ..., 10-7) comprises a ceramic cooling body (11) with a receiving surface (12) on which electronic components (24) of one phase are mounted, wherein the ceramic cooling body (11) has one or more channels in the region of the receiving surface (12) through which a coolant can flow during the operation of the converter (1);
- at least one DC link capacitor (112) and input-side and output-side power connections which are arranged on a first carrier (110), the main level of which is arranged perpendicularly to the plane of the receiving surface (12);
- a control unit for driving the electronic components (24) of the phase, wherein the control unit is arranged on a second carrier (120), the main plane of which is arranged perpendicularly to the plane of the receiving surface (12).

2. Converter according to claim 1, **characterised in that** a structural support (13, 17) is arranged at least on each of two opposing sides of the receiving surface (12), wherein the structural supports (13, 17) protrude, in a direction perpendicular to the receiving surface (12), beyond the receiving surface (12), so that the electronic components (24) then lie in a depression formed between the receiving surface (12) and the structural supports (13, 17), wherein the structural supports (13, 17) have contact portions (44, ..., 47) for an adjacent module (10; 10-1, ..., 10-7) at their ends lying in the extension direction.

3. Converter according to claim 1 or 2, **characterised in that** the thickness of the cooling body (11) in the region of the receiving surface (12) in a direction perpendicular to the plane of the receiving surface (12) is between 3 mm and 5 mm.

4. Converter according to claim 2 or 3, **characterised in that** the thickness of the structural supports (13, 17) in a direction perpendicular to the plane of the receiving surface (12) is between 15 mm and 20 mm.

5. Converter according to one of the claims 2 to 4, **characterised in that** the coolant is suppliable to and removable from the channel or channels of the cooling body (11) via the structural support or supports (13, 17).

6. Converter according to claim 5, **characterised in that** in the structural support or supports (13, 17), a common supply channel (14) extending perpendicularly to the plane of the receiving surface (12) is provided for the supply of the coolant to the channel or channels and a common removal channel (18) extending perpendicularly to the plane of the receiving surface (12) is provided for the removal of the coolant, wherein the respective volumes of the common supply channel (14) and the common removal channel (18) are very much greater than the volume of the channel or channels arranged in the region of the receiving surface (12).

7. Converter according to one of the claims 2 to 6, **characterised in that** the structural support or supports (13, 17) are made of a ceramic material and integrally with the cooling body (11) with the receiving surface (12).

8. Converter according to one of the claims 2 to 6, **characterised in that** the structural supports (13, 17) are made of a different material from the cooling bodies (11) with the receiving surface (12) and are connected with a form fit and/or force fit to one another.

9. Converter according to one of the preceding claims, **characterised in that**, in order to close the depression, provided on each side of the depression is a respective sealing plate (30, 31), which comprises a passage for control connections or supply and load connections.

10. Converter according to claim 9, **characterised in that** the control connections pass through a first of the sealing plates (30), wherein the control connections are connected mechanically and electrically outside the module (10; 10-1, ..., 10-7) to the second carrier (120) by means of a plug-in connection.

11. Converter according to claim 9 or 10, **characterised in that** the supply connections and the load connection pass through a second of the sealing plates (31), wherein the supply connections are connected mechanically and electrically outside the module (10; 10-1, ..., 10-7) to a first main side of the first carrier (110).

12. Converter according to claim 11, **characterised in that** the DC link capacitor or capacitors (112) are arranged on a second main side of the first carrier (110).

13. Converter according to one of the claims 9 to 12, **characterised in that** a first and a second supply connection are formed by sheet metal rails (32, 36) arranged over one another and separated from one another by means of an insulating layer (35).

14. Converter according to one of the claims 9 to 12, **characterised in that** the load connection is configured as a further sheet metal rail (27) which is guided over the sheet metal rails (32, 36) of the supply connections and is separated from these by means of an insulating layer (28).

15. Converter according to one of the preceding claims, **characterised in that** a plurality of modules (10; 10-1, ..., 10-7) arranged over one another are mechanically connected to one another to form a module group (100-1, 100-2, 100-3).

16. Converter according to claim 15, **characterised in that** it comprises a number of module groups (100-1, 100-2, 100-3) corresponding to the number of phases.

17. Converter according to claim 15 or 16, **characterised in that** each module group (100-1, 100-2, 100-3) is connected to a respective common second carrier (120-1, 120-2, 120-3).

18. Converter according to one of the claims 15 to 17, **characterised in that** each module group (100-1, 100-2, 100-3) is connected to the first carrier (110).

## Revendications

1. Onduleur, comprenant un circuit intermédiaire de tension continue pour transformer une tension d'entrée en une tension alternative d'amplitude et de fréquence déterminées à l'avance, pour la commande d'une charge monophasée ou polyphasée, comprenant
- un certain nombre de modules (10; 10-1,...,10-7), constitués de manière à pouvoir être empilés les uns sur les autres, chaque module (10; 10-1,...,10-7) comprenant un puits de chaleur (11) en céramique, ayant une surface (12) de réception, sur laquelle des composants (24) électroniques d'une phase sont reçus, le puits de chaleur (11) en céramique ayant, dans la région de la surface (12) de réception, un canal ou plusieurs canaux, dans lesquels, lorsque l'onduleur (1) est en fonctionnement, un fluide de refroidissement peut passer;
- au moins un condensateur (112) de circuit intermédiaire, ainsi que des bornes de puissance du côté de l'entrée et du côté de la sortie, qui sont disposées sur un premier support (110), dont le plan principal est perpendiculaire au plan de la surface (12) de réception;
- une unité de commande pour commander les composants (24) électroniques de la phase, l'unité de commande étant disposée sur un deuxième support (120), dont le plan principal est perpendiculaire au plan de la surface (12) de réception.

2. Onduleur suivant la revendication 1, **caractérisé en ce qu'**au moins sur deux faces opposées de la surface (12) de réception, est disposé respectivement un support (13, 17) de construction, les supports (13, 17) de construction dépassant de la surface de réception dans une direction perpendiculaire à la surface (12) de réception, de sorte que les composants (24) électroniques se trouvent dans un creux formé entre la surface (12) de réception et les supports (13, 17) de construction, les supports (13, 17) de construction ayant, à leurs extrémités se trouvant dans la direction dans laquelle ils s'étendent, des parties (44,..., 47) de contact avec un module (10; 10-1,..., 10-7) voisin.

3. Onduleur suivant la revendication 1 ou 2, **caractérisé en ce que** l'épaisseur du puits de chaleur (11), dans la région de la surface (12) de réception dans une direction perpendiculaire au plan de la surface (12) de réception, est compris entre 3 mm et 5 mm.

4. Onduleur suivant la revendication 2 ou 3, **caractérisé en ce que** l'épaisseur des supports (13, 17) de construction, dans une direction perpendiculaire au plan de la surface (12) de réception, est comprise entre 15 mm et 20 mm.

5. Onduleur suivant l'une des revendications 2 à 4, **caractérisé en ce que** le fluide de refroidissement peut être apporté au canal ou aux canaux du puits (11) de chaleur par le ou par les supports (13, 17) de construction et en être évacué.

6. Onduleur suivant la revendication 5, **caractérisé en ce que**, dans le ou dans les supports (13, 17) de construction, est prévu, pour l'apport du fluide de refroidissement au canal ou aux canaux, un canal (14) collecteur d'apport s'étendant perpendiculairement au plan de la surface (12) de réception et il est prévu, pour l'évacuation du fluide de refroidissement, un canal (18) collecteur d'évacuation s'étendant perpendiculairement au plan de la surface (12) de réception, le volume respectif du canal (14) collecteur d'apport et du canal (18) collecteur d'évacuation étant bien plus grand que le volume du ou des canaux se trouvant dans la partie de la surface (12) de réception.

7. Onduleur suivant l'une des revendications 2 à 6, **caractérisé en ce que** les supports (13, 17) de construction sont en matériau céramique et d'une seule pièce avec le puits de chaleur (11) ayant la surface (12) de réception.

8. Onduleur suivant l'une des revendications 2 à 6, **caractérisé en ce que** les supports (13, 17) de construction sont en un matériau autre que le puits de chaleur (11) ayant la surface (12) de réception et sont reliés entre eux par complémentarité de forme et/ou par coopération de force.

9. Onduleur suivant l'une des revendications précédentes, **caractérisé en ce que**, pour fermer la cavité, il est prévu des deux côtés de la cavité respectivement une plaque (30, 31) d'étanchéité, qui comprend un passage pour des bornes de commande ou des bornes d'alimentation et de charge.

10. Onduleur suivant la revendication 9, **caractérisé en ce que** les bornes de commande passent à travers une première des plaques (30) d'étanchéité, les bornes de commande étant à l'extérieur du module (10; 10-1,...,10-7), reliées mécaniquement et électriquement au deuxième support (120) par une liaison par enfichage.

11. Onduleur suivant la revendication 9 ou 10, **caractérisé en ce que** les bornes d'alimentation et la borne de charge passent à travers une deuxième des plaques (31) d'étanchéité, les bornes d'alimentation étant, à l'extérieur du module (10; 10-1,...,10-7), reliées mécaniquement et électriquement à une première face principale du premier support (110).

12. Onduleur suivant la revendication 11, **caractérisé en ce que** le ou les condensateurs (112) de circuit intermédiaire sont montés sur une deuxième face principale du premier support (110).

13. Onduleur suivant l'une des revendications 9 à 12, **caractérisé en ce qu'**une première et une deuxième borne d'alimentation sont formées par des barres (32, 36) en tôle, disposées l'une au-dessus de l'autre et séparées l'une de l'autre par une couche (35) isolante.

14. Onduleur suivant l'une des revendications 9 à 12, **caractérisé en ce que** la borne de charge est réalisée sous la forme d'une autre barre (27) de tôle, qui passe au-dessus des barres (32, 36) de tôle des bornes d'alimentation et en est séparée par une couche (28) isolante.

15. Onduleur suivant l'une des revendications précédentes, **caractérisé en ce que** plusieurs modules (10; 10-1,...,10-7), disposés les uns au-dessus des autres, sont reliés entre eux mécaniquement pour former un ensemble (100-1, 100-2, 100-3) de modules.

16. Onduleur suivant la revendication 15, **caractérisé en ce qu'**il comprend un nombre d'ensembles (100-1, 100-2, 100,3) de modules correspondant au nombre de phases.

17. Onduleur suivant la revendication 15 ou 16, **caractérisé en ce qu'**un ensemble (100-1, 100-2, 100-3) de modules respectifs est relié à un deuxième support (120-1, 120-2, 120-3) commun.

18. Onduleur suivant l'une des revendication 15 à 17, **caractérisé en ce qu'**un ensemble (100-1, 100-2, 100-3) de modules respectifs est relié au premier support (110).
